(19) Europäisches Patentamt

European Patent Office

Office européen des brevets

(11) Veröffentlichungsnummer : **0 371 069 B1**

(12) **EUROPÄISCHE PATENTSCHRIFT**

(45) Veröffentlichungstag der Patentschrift :
**13.05.92 Patentblatt 92/20**

(51) Int. Cl.$^5$ : **G01P 15/16, G03F 7/00**

(21) Anmeldenummer : **88907108.0**

(22) Anmeldetag : **08.08.88**

(86) Internationale Anmeldenummer :
**PCT/DE88/00488**

(87) Internationale Veröffentlichungsnummer :
**WO 89/01632 23.02.89 Gazette 89/05**

(54) **VERFAHREN ZUR HERSTELLUNG VON MIKROSENSOREN MIT INTEGRIERTER SIGNALVERARBEITUNG.**

(30) Priorität : **14.08.87 DE 3727142**

(43) Veröffentlichungstag der Anmeldung :
**06.06.90 Patentblatt 90/23**

(45) Bekanntmachung des Hinweises auf die Patenterteilung :
**13.05.92 Patentblatt 92/20**

(84) Benannte Vertragsstaaten :
**AT CH FR GB IT LI NL SE**

(56) Entgegenhaltungen :
**IEEE Transactions on Electron Devices, vol. ED-29, No. 1, January 1982, IEEE, (New York, US), K.E. Petersen et al.:"Micromechanical accelerometer integrated with MOS detection circuitry", pages 23-27
Technische Rundschau, vol. 79, no. 13, 27 March 1987, (Bern, CH), E.-K. Aschmoneit: "LIGA: Mikrostrukturen, lithographischherge-stellt", pages 54-57**

(56) Entgegenhaltungen :
**Technische Rundschau, vol. 78, No. 35, August 1986, (Bern, CH), H. Benninghof: "Mikrostrukturtechnologie für innovativePro-dukte", pages 32-37 see pages 34-35, chapter: "Mikrofertigung nach dem LIGA-Verfahren"; pages 35-36, chapter: "Mikromechanik undsi-liziumtechnologie"**

(73) Patentinhaber :
**KERNFORSCHUNGSZENTRUM KARLSRUHE GMBH
Weberstrasse 5 Postfach 3640
W-7500 Karlsruhe 1 (DE)**

(72) Erfinder : **EHRFELD, Wolfgang
Reutstr. 27
W-7500 Karlsruhe 41 (DE)**
Erfinder : **GÖTZ, Friedrich
Rintheimer Hauptstr. 101
W-7500 Karlsruhe 1 (DE)**
Erfinder : **SCHELB, Werner
Birkenstr. 10
W-7504 Pfinztal 1 (DE)**
Erfinder : **SCHMIDT, Dirk
Ringstr. 3
W-7513 Stutensee 1 (DE)**

**Beschreibung**

Die Erfindung betrifft ein Verfahren zur Herstellung von Mikrosensoren mit integrierter Signalverarbeitung gemäß dem Oberbegriff von Patentanspruch 1.

Zur Herstellung von Mikrosensoren gattungsgemäßen Art ist es bekannt, Methoden der Halbleitertechnik und der anisotropen Siliziumätztechnik miteinander zu kombinieren, um in einer Fertigungsfolge die elektronischen Schaltkreise und die damit gekoppelten Sensorstrukturen auf einem Siliziumwafer herzustellen. Eine derartige Vorgehensweise zur Herstellung eines kapazitiven Beschleunigungssensors ist in K.E. Petersen, A. Shartel and N.F. Raley "Micromechanical Accelerometer Integrated with MOS Detection Circuitry", IEE Transactions on Electron Devices, Vol. ED-29, No. 1, January 1982, pp. 23 to 27, beschrieben und dargestellt. Gemäß Figur 1 dieser Veröffentlichung wird zunächst als Elektrode und Ätzstoppschicht eine strukturierte p-dotierte Schicht in der Oberfläche eines Si-Wafers erzeugt. Sodann wird epitaktisch Silizium in einer dem Elektrodenabstand entsprechenden Dicke abgeschieden und eine strukturierte Siliziumoxidschicht erzeugt. Durch die Öffnung in der Siliziumoxidschicht wird mittels anisotroper Ätztechnik ein Kontaktloch durch die epitaktische Siliziumschicht zur vergrabenen Elektrode hergestellt. Durch Dotieren werden Source- und Drainbereich und die elektrische Verbindung im Kontaktloch erzeugt. Danach wird das Gateoxid erzeugt und ein Ätzfenster in der Siliziumoxidschicht zur späteren Bildung der Sensorstruktur in Form einer Zunge freigelegt. Sodann werden die elektrischen Verbindungen erzeugt und der Zungenbereich metallisiert. Als letzter Schritt wird durch anisotropes Siliziumätzen eine Grube zwischen der vergrabenen Elektrode und dem Siliziumoxid gebildet, wodurch eine schwingfähige Zunge aus metallisiertem Siliziumoxid entsteht. Nachteilig bei dieser Fertigungsfolge wirkt sich aus, daß Standardhalbbleiterprozesse wie z.B. das Oxidieren und das Dotieren in wechselnder Folge mit anisotropen Siliziumätzprozessen angewendet werden. Dies führt zu Problemen bei der Serienfertigung, da durch die Verwendung alkalischer Ätzmittel beim anisotropen Ätzen die Gefahr besteht, daß die Eigenschaften der elektronischen Schaltkreise in unerwünschter Weise verändert werden.

Die Erfindung hat zur Aufgabe, ein Verfahren zur Herstellung von Mikrosensoren der gattungsgemäßen Art zur Verfügung zu stellen, bei dem die Herstellungsschritte für die Sensorstrukturen keine negativen Auswirkungen auf die damit gekoppelten elektronischen Schaltkreise haben.

Zur Lösung dieser Aufgabe werden die im Kennzeichen von Anspruch 1 enthaltenen Verfahrensschritte vorgeschlagen. Die hierauf bezogenen Unteransprüche beinhalten vorteilhafte Ausgestaltungen dieser Lösung.

Die Herstellung von Mikrostrukturen auf röntgenlithographischem Wege (LIGA-Verfahren) ist in der Zeitschrift "Technische Rundschau" (T.R.) 78, 1986, No. 35, Seiten 34, 35 und T.R. 79 (1987), No. 13, Seiten 54 bis 57 beschrieben. In T.R.78 (1986), No. 35, Seite 34 wird u.a. auf die Anwendungsmöglichkeit des LIGA-Verfahrens bei der Sensortechnik hingewiesen. Die Gesamtkombination der Verfahrensschritte von Anspruch 1 zur Herstellung gattungsgemäßer Mikrosensoren mit integrierter Signalverarbeitung ist aus diesen Veröffentlichungen jedoch nicht herleitbar.

Das erfindungsgemäße Verfahren hat den Vorteil, daß die Herstellung der Sensorstrukturen unabhängig von der Herstellung der elektronischen Schaltkreise ist und letztere nicht beinflußt. Ausführungsbeispiele der Erfindung werden im folgenden anhand der Zeichnungen erläutert:

Figuren 1 bis 3 zeigen die Herstellung eines induktiven Abstandssensors nach dem erfindungsgemäßen Verfahren,

Figuren 4 bis 7 zeigen die Herstellung eines kapazitiven Beschleunigungssensors,

Figuren 8 bis 15 zeigen die Herstellung eines kapazitiven Beschleunigungssensors für die Messung sehr kleiner Beschleunigungen.

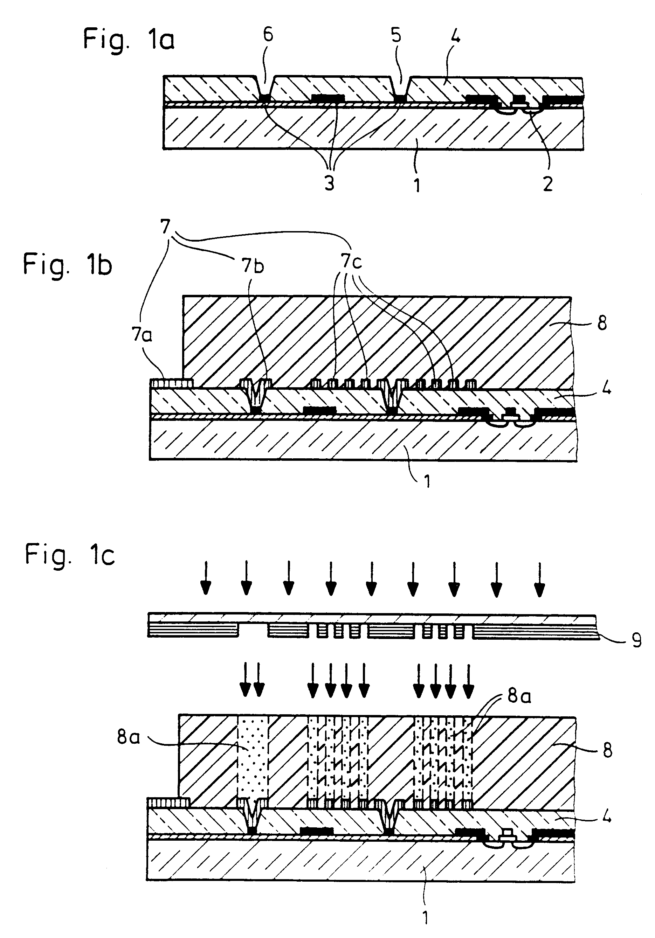

Figur 1a zeigt schematisch einen Ausschnitt eines Substrats in Form eines Siliziumwafers 1, auf dem ein elektronischer Schaltkreis, symbolisiert durch eine MOSFET-Struktur 2 und einige Leiterbahnen 3, nach bekannten Methoden der Halbleitertechnik aufgebracht wurde.

Der gesamte Wafer mit darauf befindlichen Schaltkreisen wird mit einer isolierenden Schutzschicht 4 aus Siliziumnitrid überzogen, in die unter Anwendung bekannter lithographischer und ätztechnischer Methoden der Halbleiterfertigung über den entsprechenden Stellen der Schaltkreise Kontaktöffnungen 5,6 für die Anschlußflächen der herzustellenden Sensorstruktur und für die externen Kontakte der Schaltkreise erzeugt wurden.

Gemäß Figur 1b wird auf diese Schutzschicht 4 eine leitfähige Schicht aus Kupfer aufgesputtert und mittels lithographischer und ätztechnischer Methoden so strukturiert, daß nach Maßgabe des Grundrisses der herzustellenden Sensorstrukturen sowie der erforderlichen Leiterbahnen und Anschlüsse eine flächenhaft strukturierte Galvanikelektrode 7 entsteht.

Sodann wird der gesamte Wafer 1 mit Ausnahme des verkupferten ringförmigen Randes 7a mit einer 300 µm dicken Schicht 8 eines Positiv-Röntgenresists (PMMA) beschichtet.

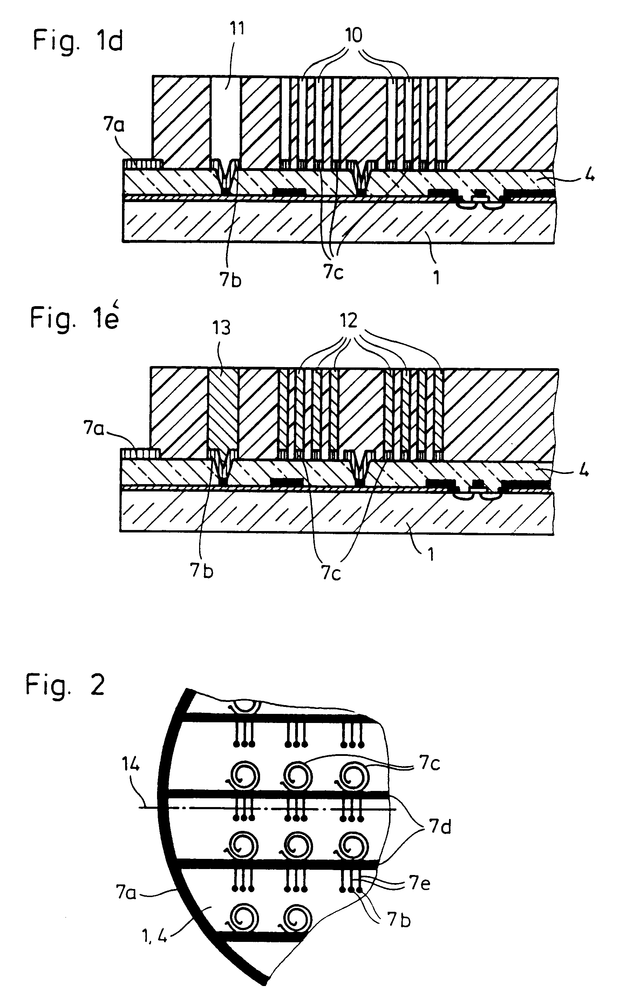

Über eine Röntgenmaske 9 wird die Resistschicht mit der Röntgenstrahlung eines Synchrotrons partiell bestrahlt (s.Pfeile in Figur 1c). Nach dem Herauslösen der bestrahlten Bereiche 8a entstehen Negative 10, 11 der Sensorstrukturen und der Anschlußpunkte (Figur 1d). Hierzu muß die Röntgenmaske 9 so justiert werden, daß die entstehenden Negative 10, 11 kongruent zur zuvor strukturierten Galvanikelektrode 7 sind. Hierauf wird in die Negative 10, 11 galvanisch Kupfer abgeschieden, wobei die Galvanikelektrode 7 über dem freigehaltenen ringförmigen Rand 7a kontaktiert wird. Nach Überfräsen des Resists mit den darin eingebetteten Kupferstrukturen 12, 13 (Figur 1e) auf eine Solldicke von 250 µm wird das Substrat in einzelne Sensorchips zersägt.

In der Figur 2 ist in der Draufsicht ein Ausschnitt aus der strukturierten Galvanikelektrode 7 auf dem beschichteten Wafer 1,4 gezeigt. Die dem Grundriß der Sensorstrukturen entsprechenden spiralförmigen Teile 7c der Elektrode 7 sind über Bahnen 7d zeilenweise mit dem ringförmigen Rand 7a der Galvanikelektrode verbunden, während die den äußeren Kontakten entsprechenden Teile 7b mit der jeweils nächsten Bahn verbunden sind. Beim Aufteilen in die einzelnen Chips wird die über die Bahnen 7d und die hierzu senkrecht verlaufenden Stege 7e bestehende elektrische Kurzschlußverbindung zwischen den äußeren Anschlüssen der Schaltung unterbrochen (s. Schnittlinie 14).

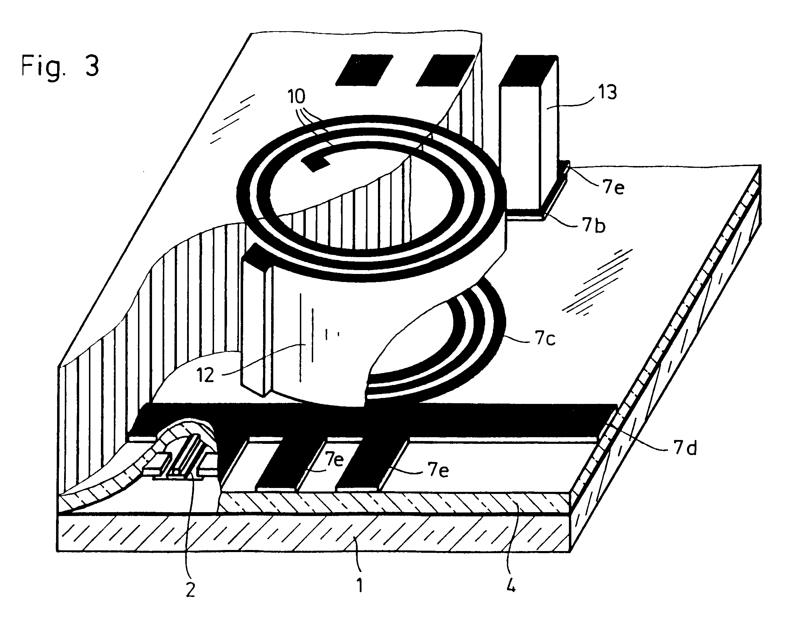

Die Figur 3 zeigt in perspektivischer Ansicht und teilweise aufgerissen schematisch den so hergestellten Abstandssensor mit der spiralförmigen Tellerspule 12 als Sensorstruktur, der strukturierten Galvanikelektrode 7 und die von der Isolierschicht 4 überdeckten elektronischen Schaltkreise 2 auf dem Siliziumwafer 1. Von der Tellerspule 12 mit 50 Windungen mit einer Windungsbreite und einem Windungsabstand von je 25 µm und einer Höhe von 250 µm sind aus darstellungstechnischen Gründen nur wenige Windungen nicht maßstabsgemäß gezeigt. Die externe Kontaktierung erfolgt über die Säulenstrukturen 13. Das Beispiel zeigt, daß das erfindungsgemäße Verfahren zur Massenfertigung von Sensoren mit induktiv arbeitenden Elementen und mit integrierter Signalverarbeitung geeignet ist. Da die Geometrie der Sensorstruktur in lateraler Richtung frei wählbar ist, lassen sich auch erheblich kompliziertere Sensorstrukturen als in diesem Beispiel realisieren.Durch die Kombination von charakteristischen Abmessungen im Mikrometerbereich mit einer großen Strukturhöhe, die bei der Fertigung nach dem erfindungsgemäßen Verfahren für die Sensorstrukturen erreicht wird, können die Sensorstrukturen entweder bei gleichen Leistungsdaten miniaturisiert oder bei gleicher Geometrie in ihren Leistungsdaten (z.B. der Strombelastbarkeit) verbessert werden. Da mit dem erfindungsgemäßen Verfahren eine hohe Präzision der Geometrie der Sensorstrukturen erreicht wird und durch den integrierten Aufbau die mit den Anschlußkabeln verbundene Problematik entfällt, können die aufwendigen Abgleichsund Justierarbeiten entfallen, und das Sensorelement kann bei Defekten mit geringem Aufwand ausgetauscht werden.

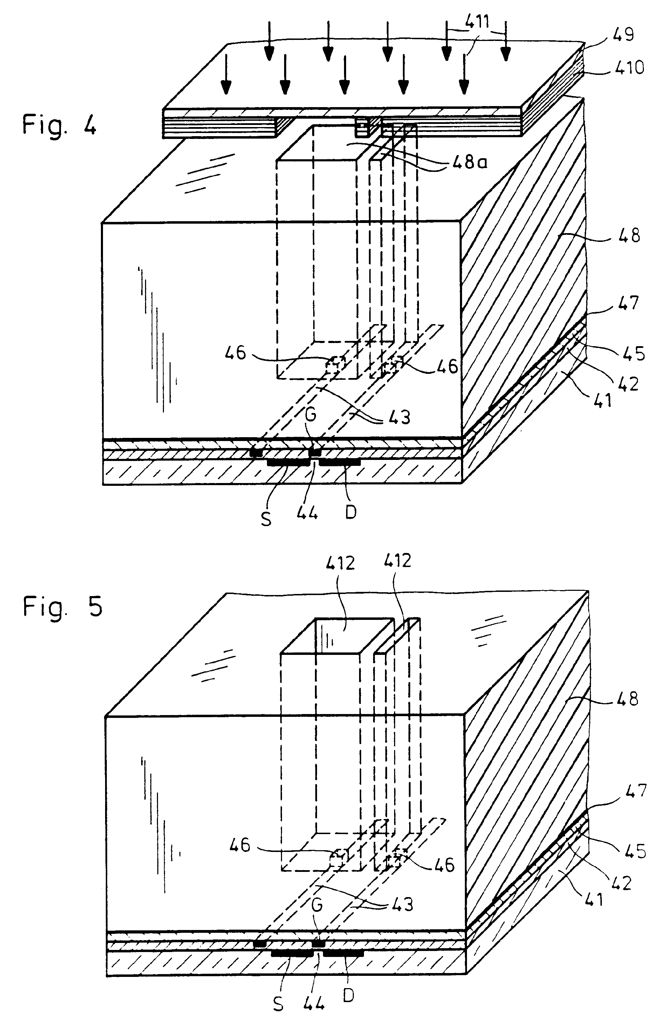

Die Figur 4 zeigt perspektivisch einen Ausschnitt eines Siliziumwafers 41, auf dem nach bekannten Methoden der Halbleitertechnik ein elektronischer Schaltkreis 44, die Oxidschicht 42 und die Leiterbahnen 43 gefertigt wurden. Auf den Wafer wird eine isolierende Schutzschicht 45, z.B. aus Siliziumnitrid, aufgebracht. Durch einen aus der Halbleitertechnik bekannten Lithographie- und Ätzschritt werden die Kontaktöffnungen 46 für die Kopplung zwischen Sensorstruktur und Schaltkreis erzeugt. Nunmehr wird z.B. durch Aufdampfen eine das gesamte Substrat überdeckende Leitschicht 47 als Galvanikelektrode aus z.B. Nickel auf das mit der Schutzschicht 45 versehene Substrat aufgebracht. Sodann erfolgt das Aufbringen einer etwa 1000 µm dicken Schicht 48 eines Röntgenresists. Die Resistschicht 48 wird über eine Röntgenmaske 49 mit Absorberstrukturen 410 mit der extrem parallelen und intensiven Strahlung 411 aus z.B. einem Synchrotron belichtet.

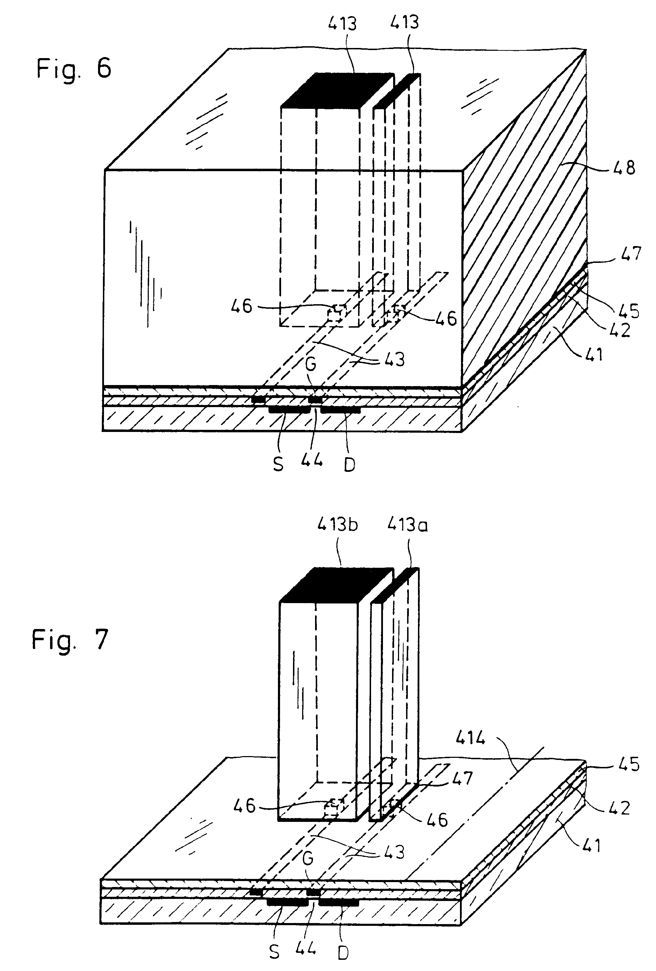

Die Röntgenmaske 49 wird dabei so zum Wafer 41 justiert, daß die herzustellenden Sensorstrukturen über den entsprechenden Kontaktöffnungen 46 entstehen. Bei der Bestrahlung werden die Bereiche 48a der Resistschicht 48, die nicht von den Absorberstrukturen 410 abgeschattet werden, strahlenchemisch verändert. Nach der Bestrahlung werden beim Entwickeln die der Strahlung ausgesetzten Bereiche 48a der Resistschicht 48 herausgelöst, so daß Negative 412 (Figur 5) der Sensorstruktur entstehen. In diese Negative 412 wird unter Verwendung der Leitschicht 47 als Galvanikelektrode ein Metall 413, z.B. Nickel, galvanisch abgeschieden (Figur 6). Nach der Herstellung der metallischen Sensorstrukturen 413 werden der restliche Resist 48 gestrippt und die freigelegten Bereiche der Leitschicht 47 z.B. trocken weggeätzt (Figur 7). Der Prozeß schließt mit dem Aufteilen des Wafers mit den darauf aufgebrachten Sensorstrukturen in einzelne Funktionseinheiten (Chips) mit Hilfe z.B. einer Diamantkreissäge entlang der Schnittlinie 414.

Die so gefertigte Sensorstruktur besteht aus einer Kapazität von z.B. 1 pF, die aus einer schwingfähigen Elektrode in Form eines freistehenden Balkens 413a mit einer Höhe von etwa 1000 µm, einer Breite von 350 µm und einer Dicke von 3 µm sowie einer feststehenden Gegenelektrode 413b gebildet wir413ad. Die schwingfähige Elektrode 413a ist direkt mit dem Gate G z.B. eines MOSFET-Schaltkreises 44 verbunden.

Durch die frei wählbare Geometrie der Sensorstrukturen in lateraler Richtung und Variation der Strukturhöhe bis zu maximal ca. 1000 µm können mit dem erfindungsgemäßen Verfahren kapazitive Beschleunigungssensoren hergestellt werden, deren Empfindlichkeit und Meßbereich optimal an den jeweiligen Einsatz des Sensors angepaßt werden können. Durch die große Auswahl von Metallen für die Elektroden der Kapazität ist ebenfalls eine optimale Anpassung des Schwingverhaltens (Frequenzbereich) an den jeweiligen Einsatz des Sensors möglich.

Durch die Verwendung einer zweiten Gegenelektrode auf der anderen Seite des Balkens ist eine einfache Kompensation der Temperaturfehler durch thermische Ausdehnung der Elektroden und des Wafers möglich. Durch den gleichzeitigen Aufbau von zwei in einem Winkel zueinander angeordneten beschleunigungsempfindlichen Strukturen auf einem Chip kann ein 2-Achsen-Beschleunigungssensor mit integrierter Signalverarbeitung hergestellt werden (nicht dargestellt).

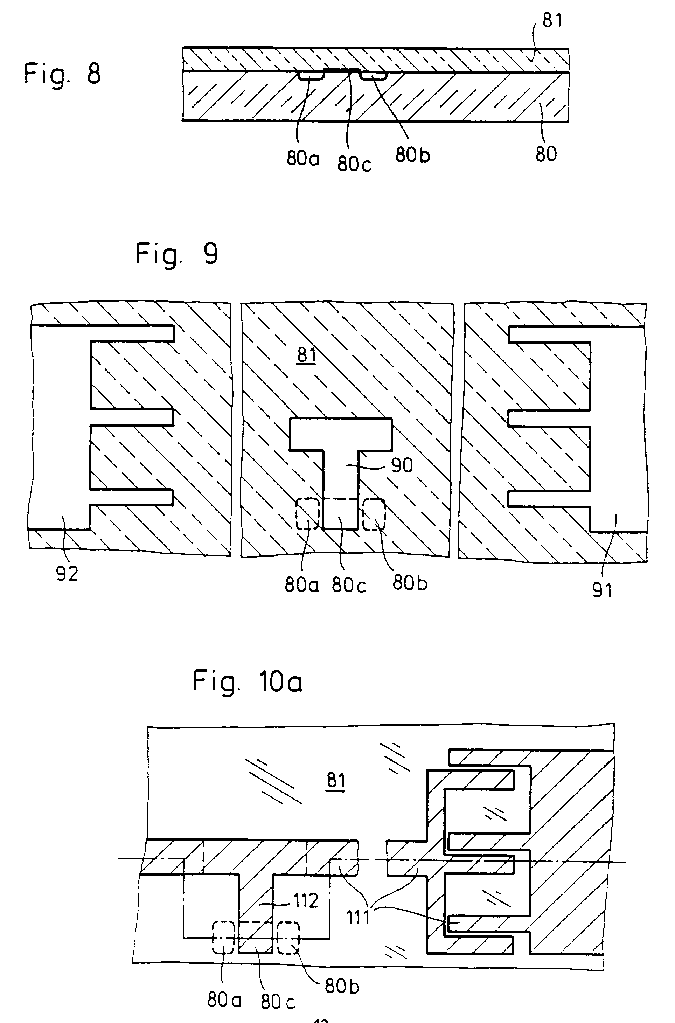

Im folgenden wird die Herstellung eines kapazitiven Beschleunigungssensors beschrieben, der besonders gut für die Messung kleiner Beschleunigungen geeignet ist. Die Herstellung geht gemäß Figur 8 aus von einem mit einem elektronischen Schaltkreis versehenen Substrat 80. Als Verbindungsglied zwischen diesem Schaltkreis und der zu fertigenden mikromechanischen Sensorstruktur dient ein MOS-Transistor, der schematisch mit Source 80a, Drain 80b und Gate einschließlich Gateoxid 80c gezeichnet ist. Aus Gründen der besseren Übersichtlichkeit sind die weiteren Elemente des Schaltkreises und die Anschlußkontakte weggelassen. Auf das Substrat 80 wird eine Polyimidschicht 81 aufgebracht, die später als wieder entfernbare Zwischenschicht zwischen einem Teil der herzustellenden Sensorstrukturen und dem Substrat dient. Diese Schicht 81 wird mit lithographischen und ätztechnischen Methoden so strukturiert, daß über dem Gate 80c des MOS-Transistors und in einem sich daran anschließenden Bereich ein T-förmiger Durchbruch 90 entsteht (Figur 9). Weitere Durchbrüche 91, 92 sind so strukturiert, daß siee dem Grundriß der kammförmigen Gegenelektroden der aufzubauenden Sensorstruktur entsprechen.

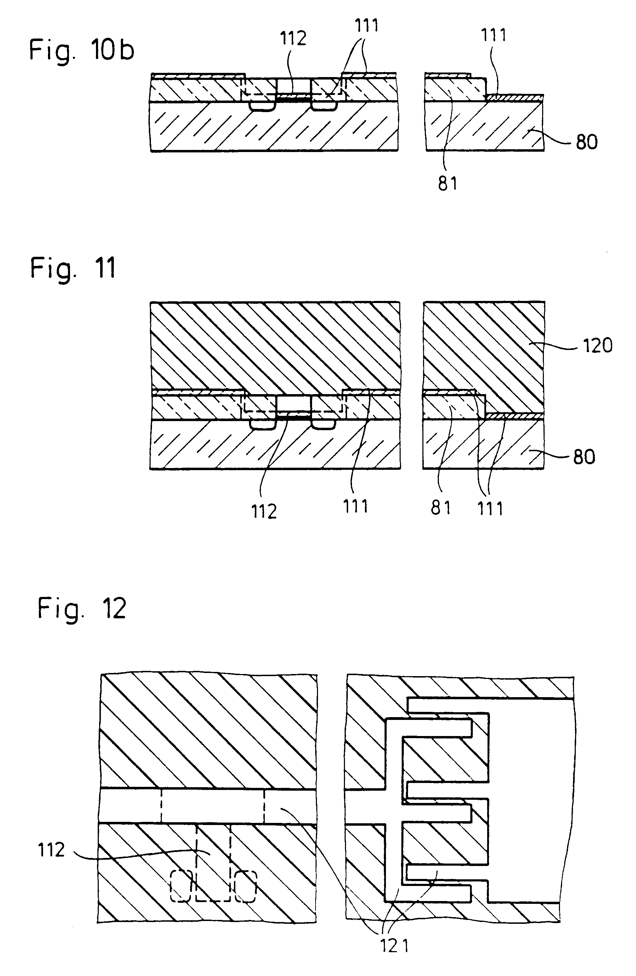

Hierauf erfolgt eine Metallisierung der Oberfläche mit anschließender lithographischer und ätztechnischer Strukturierung in der Weise, daß eine als Galvanikelektrode verwendbare Struktur verbleibt, die zum einen dem Grundriß 111 der Sensorstruktur entspricht und zum anderen eine elektrisch leitende Verbindung 112 zum Gate 80c des MOS-Transistors herstellt (Figur 10a, 10b). Nun wird auf die Oberfläche eine dicke Schicht 120 (Figur 11) eines Positiv-Röntgenresists aufgebracht, der so über eine Röntgenmaske in Teilbereichen mit Synchrotronstrahlung bestrahlt wird, daß nach dem Weglösen der bestrahlten Bereiche ein Negativ 121 der Sensorstrukturen entsteht, woGrundrissesbei die herausgelösten Bereiche dem Grundriß 111 der Sensorstrukturen entsprechen (Figur 12).

Dabei wird die in Figur 8 dargestellte Polyimidzwischenschicht 81 noch nicht weggelöst.

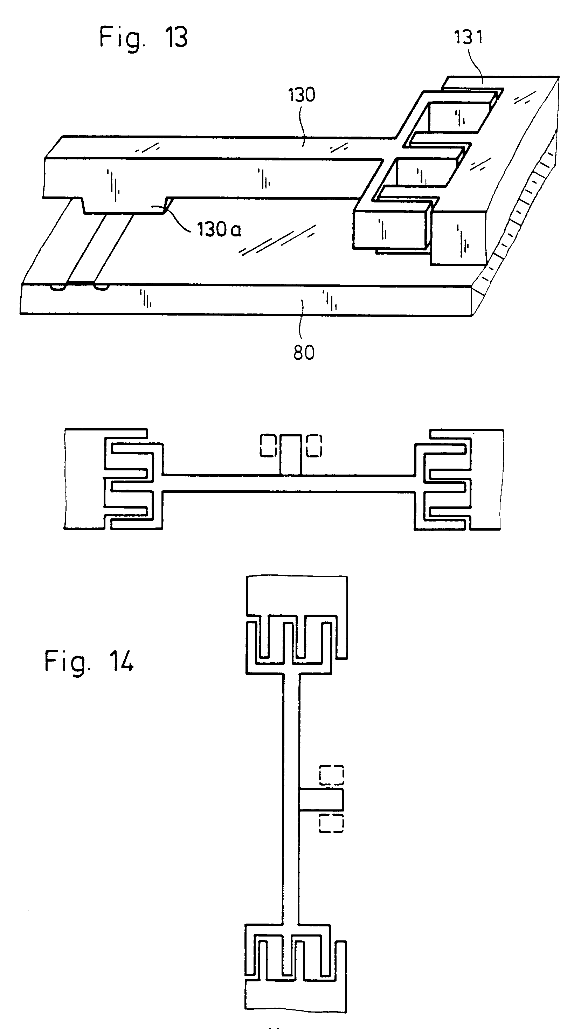

Die so geschaffenen Vertiefungen über dem Grundriß 111 werden sodann galvanisch mit Nickel aufgefüllt, wodurch die in den Resist eingebettete Sensorstruktur in Form kammförmig ineinander greifender Elektroden 130, 131 gebildet wird (Figur 13). Als nächster Schritt wird, ggf. nach vorhergehendem Einebnen der Oberfläche, das Substrat, auf dem gleichzeitig eine Vielzahl derartiger Sensorstrukturen aufgebaut werden, in einzelne Chips aufgeteilt. Sodann werden der restliche Resist 120 (Figur 12) weggelöst und die Polyimidzwischenschicht 81 mittels eines Sauerstoff-Niederdruckplasmas chemisch entfernt.

Wie aus Figur 13 zu ersehen ist, hat die eine Elektrode 130 der Sensorstruktur die Gestalt eines Biegebalkens mit kammförmigen Enden, wobei bei symmetrischem Aufbau der Biegebalken nur in seinem mittleren Bereich 130a mit dem Substrat 80 fest verbunden ist, während die übrigen Bereiche das Substrat nicht berühren und daher in der Substratebene frei auslenkbar sind. Die Gegenelektrode 131 hingegen ist fest mit dem Substrat 80 verbunden. Die Kämme greifen hierbei assymmetrisch ineinander.

Die beschriebene Sensoranodnung mit einem symmetrischen Biegebalken hat den Vorteil, daß sehr geringe Translationsbeschleunigungen unabhängig von überlagerten Winkelbeschleunigungen gemessen werden können, wobei die Größe der Winkelbeschleunigung in gleicher Größenordnung wie die Linearbeschleunigung liegen kann. Durch die gleichzeitige Herstellung zweier solcher Beschleunigungssensoren in senkrechtem Winkel zueinander auf demselben Chip gemäß Figur 14 ist damit eine winkelbeschleunigungsfreie Messung der Linearbeschleunigung in zwei Raumrichtungen möglich ohne zusätzliche Justierung.

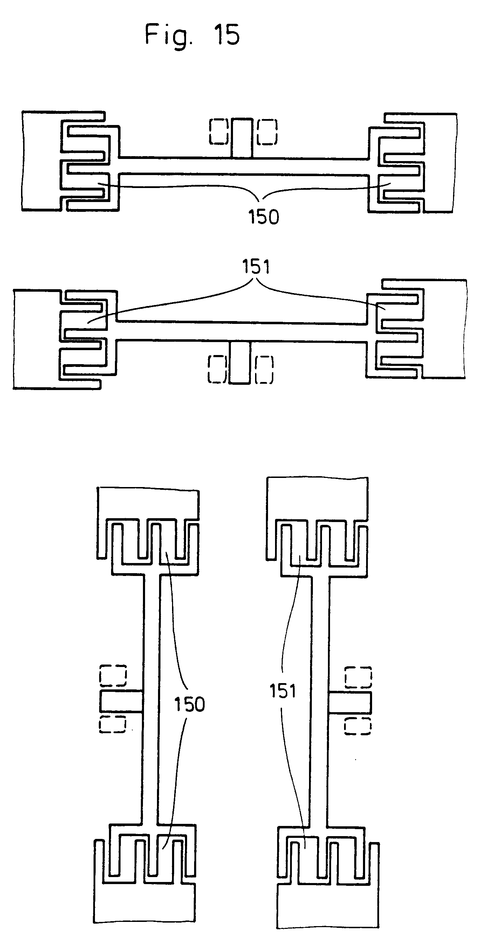

Mit einer leicht modifizierten Ausführung gemäß Figur 15 ist darüber hinaus die gleichzeitige Messung von Linear- und Winkelbeschleunigungen möglich, indem zwei Sensoranordnungen parallel zueinander auf einem gemeinsamen Chip hergestellt werden. Die assymetrische Lage der Kämme zueinander ist hierbei so getroffen, daß die Anordnung 150 nur auf Linearbeschleunigungen anspricht und gegenüber Winkelbeschleunigungen unempfindlich ist. Bei der Anordnung 151 ist es umgekehrt, d.h. Winkelbeschleunigungen werden angezeigt, während bei Linearbeschleunigungen die Kapazitätsänderungen auf der linken und der rechten Seite des Biegebalkens sich kompensieren, also zu keiner Anzeige führen.

Die Sensorstrukturen können nicht nur, wie vorstehend beschrieben, auf der selben Seite wie die Schaltkreise, sondern auch auf der anderen Seite des Substrats aufgebaut werden. Bei komplexen Anordnungen können auch beide Seiten des Substrats mit Sensoranordnungen versehen werden. Auch in diesen Fällen wird die räumlich unmittelbar benachbarte Fertigung der Sensorstrukturen und der jeweils zugehörigen mit diesen gekoppelten Mikro-Schaltkreise zur integrierten Signalverarbeitung realisiert.

Das Resistmaterial kann vor oder nach dem Zerteilen des Substrats entfernt werden. Das Entfernen nach dem Zerteilen hat den Vorteil, daß die empfindlichen Sensorstrukturen im Resistmaterial eingebettet und damit geschützt sind und das Zersägen erleichtert wird.

EP 0 371 069 B1

**Patentansprüche**

1. Verfahren zur Herstellung von Mikrosensoren mit integrierter Signalverarbeitung, bei dem die elektronischen Schaltkreise für die Signalverarbeitung und die mit diesen gekoppelten Sensorstrukturen auf einem gemeinsamen Substrat räumlich unmittelbar benachbart gefertigt werden, das folgende Verfahrensschritte aufweist:

a) Fertigung der elektronischen Schaltkreise auf dem Substrat nach Methoden der Halbleitertechnik;

b) Aufbringen einer leitfähigen Schicht auf dem Substrat, die so strukturiert wird, daß nach Maßgabe des Grundrisses der herzustellenden Sensorstrukturen sowie der erforderlichen Leiterbahnen und Anschlüsse für die Schaltkreise eine flächenhaft strukturierte Galvanikelektrode entsteht;

c) Aufbringen einer Schicht eines Röntgenresists auf dem mit der Galvanikelektrode versehenen Substrat, wobei die Dicke der Schicht einer charakteristischen Höhe der Sensorstrukturen entspricht;

d) Herstellen von Negativen der Sensorstrukturen in dieser Schicht auf röntgenlithographischem Wege;

e) galvanische Abscheidung eines Metalls oder einer Metallegierung in die Negative der Sensorstrukturen unter Verwendung der Galvanikelektrode;

f) Aufteilen des Substrats mit den darauf aufgebrachten Sensorstrukturen in einzelne Funktionseinheiten (Chips).

2. Verfahren nach Anspruch 1, dadurch gekennzeichnet, daß die restliche Schicht des Röntgenresists nach dem Aufteilen des Substrats entfernt wird.

3. Verfahren nach Anspruch 2, dadurch gekennzeichnet, daß auf das Substrat partiell eine Zwischenschicht aufgebracht wird, die sich unterhalb von Teilen der herzustellenden Sensorstrukturen erstreckt und die nach dem Entfernen des restlichen Schicht des Röntgenresists ebenfalls entfernt wird.

4. Verfahren nach Anspruch 1, dadurch gekennzeichnet, daß nach der Fertigung der elektronischen Schaltkreise gemäß a) auf dem Substrat eine isolierende Schutzschicht mit Kontaktöffnungen für die Kopplung zwischen den Sensorstrukturen und den Schaltkreisen erzeugt wird, worauf die Galvanikelektrode gemäß b) hergestellt wird.

5. Verfahren nach Anspruch 2, dadurch gekennzeichnet, daß nach der Fertigung der elektronischen Schaltkreise gemäß a) auf dem Substrat eine isolierende Schutzschicht mit Kontaktöffnungen für die Kopplung zwischen den Sensorstrukturen und den Schaltkreisen erzeugt wird, worauf als Galvanikelektrode gemäß b) eine das gesamte Substrat überdeckende Leitschicht aufgebracht wird, und daß nach dem Entfernen des restlichen Schicht des Röntgenresists die freigelegten Bereiche der Leitschicht ganz oder teilweise entfernt werden.

**Claims**

1. Method of producing microsensors with integrated signal processing, wherein the electronic circuits for the signal processing and the sensor structures, to which they are coupled, are manufactured side by side on a common substrate, has the following method steps:

a) manufacture of the electronic circuits on the substrate by semiconductor techniques;

b) application of a conductive layer to the substrate, which layer has such a structure that a galvanic electrode of a planar structure results in accordance with the outline configuration of the sensor structures to be produced and the required conductor paths and connections for the circuits;

c) application of a layer of an X-ray resist to the substrate, which is provided with the galvanic electrode, the thickness of the layer corresponding to a characteristic height of the sensor structures;

d) production of negatives of the sensor structures in this layer by X-ray lithography;

e) galvanic deposition of a metal or a metal alloy in the negatives of the sensor structures, using the galvanic electrode; and

f) division of the substrate, with the sensor structures applied thereto, into individual functional units (chips).

2. Method according to claim 1, characterised in that the remaining layer of the X-ray resist is removed after the substrate has been divided.

3. Method according to claim 2, characterised in that an intermediate layer is applied partially to the substrate, such intermediate layer extending beneath portions of the sensor structures to be produced and being also removed after the remaining layer of the X-ray resist has been removed.

4. Method according to claim 1, characterised in that, after the electronic circuits of a) have been manufactured on the substrate, an insulating protective layer is produced with contact openings for the coupling between the sensor structures and the circuits, whereupon the galvanic electrode of b) is produced.

5. Method according to claim 2, characterised in that, after the electronic circuits of a) have been manufactured on the substrate, an insulating protective layer is produced with contact openings for the coupling between the sensor structures and the circuits, whereupon a conductive layer, which covers the entire substrate, is applied as the galvanic electrode of b), and in that, after the remaining layer of the X-ray resist has been removed, the exposed regions of the conductive layer are wholly or partially removed.

**Revendications**

1. Procédé pour fabriquer des micro-détecteurs à traitement intégré de signaux, procédé dans lequel les circuits électroniques de commutation pour le traitement des signaux et les structures de détecteurs couplées à ces circuits, sont fabriqués sur un substrat commun dans le voisinage immédiat les uns et les autres, ce procédé comportant les étapes suivantes :

a) fabrication des circuits électroniques de commutation sur le substrat, selon les méthodes de la technique des semi-conducteurs,

b) application sur le substrat des couches conductrices qui est structuré de façon que selon l'importance du plan d'ensemble des structures de détecteurs à réaliser, ainsi que des pistes conductrices nécessaires et des raccordements pour les circuits de commutation, il en résulte une électrode galvanique structurée en deux dimensions,

c) application d'une couche d'un résiste aux rayons X sur le substrat muni de l'électrode galvanique, l'épaisseur de cette couche correspondant à une hauteur caractéristique des structures de détecteurs,

d) fabrication de négatifs des structures de détecteurs dans cette couche par des moyens radio lithographiques,

e) séparation galvanique d'un métal ou bien d'un alliage d'un métal dans les négatifs des structures de détecteurs en utilisant l'électrode galvanique,

f) division du substrat, comportant les structures de détecteurs rapportées sur lui, en unités fonctionnelles individuelles (puces).

2. Procédé selon la revendication 1, caractérisé en ce que la couche résiduelle du résiste aux rayons X est enlevée après la division du substrat

3. Procédé selon la revendication 2, caractérisé en ce qu'on rapporte partiellement sur le substrat, une couche intermédiaire qui s'étend sous des parties des structures de détecteurs à réaliser et qui est également enlevée après l'enlèvement de la couche résiduelle du résiste aux rayons X.

4. Procédé selon la revendication 1, caractérisé en ce qu'après la fabrication des circuits électroniques de commutation selon a), une couche de protection isolante est créée sur le substrat avec des ouvertures de contacts pour le couplage entre les structures de détecteurs et les circuits de commutation, après quoi l'électrode galvanique est fabriquée selon b).

5. Procédé selon la revendication 2, caractérisé en ce qu'après la fabrication des circuits électroniques de commutation selon a), une couche de protection isolante est créée sur le substrat avec des ouvertures de contact pour le couplage entre les structures de détecteurs et les circuits de commutation, après quoi, comme électrode galvanique selon b), une couche conductrice recouvrant l'ensemble du substrat est rapportée, et en ce qu'après l'enlèvement de la couche résiduelle du résiste aux rayons X, les régions mises à nu de la couche conductrice sont enlevées en totalité ou partiellement.

Fig. 1a

Fig. 1b

Fig. 1c

Fig. 1d

Fig. 1e

Fig. 2

Fig. 3

Fig. 4

411

49

410

48a

48

47

45

42

41

46

46

43

G

S   44   D

Fig. 5

412   412

48

47

45

42

41

46

46

43

G

S   44   D

10

Fig. 6

Fig. 7

Fig. 8

Fig. 9

Fig. 10a

12

Fig. 10b

Fig. 11

Fig. 12

Fig. 13

131

130

130a

80

Fig. 14

# Fig. 15

150

151

151

150

151